# EUROPÄISCHE PATENTSCHRIFT

(11) **EP 0 306 077 B1**
(45) Veröffentlichungstag und Bekanntmachung des Hinweises auf die Patenterteilung: **30.03.1994**
(21) Anmeldenummer: 88201778.3
(22) Anmeldetag: 19.08.1988
(51) Int. Cl.: C23C 30/00, C23C 28/02

(54) **Verfahren zur Herstellung mehrlagig beschichteter Hartmetallteile**
Process for the production of multilayer coated hard metal parts
Procédé de production de pièces en alliage dur ayant un revêtement multicouche

(30) Priorität: 31.08.1987 AT 2173/87
(43) Veröffentlichungstag der Anmeldung: 08.03.1989
(73) Patentinhaber: PLANSEE TIZIT GESELLSCHAFT M.B.H., 6600 Reutte/Tirol (AT)
(72) Erfinder: Schintlmeister, Wilfried, Dr., A-6600 Mühl / Reutte (AT); Wallgram, Wolfgang, A-6600 Breitenwang (AT)
(74) Vertreter: Lohnert, Wolfgang, Dr.

(56) Entgegenhaltungen:
- EP-A- 0 083 043
- FR-A- 2 370 551
- US-A- 4 239 536
- PATENT ABSTRACTS OF JAPAN, Band 6, Nr. 102, (C-107)[980], 11. Juni 1982; & JP-A-57 32 366
- PATENT ABSTRACTS OF JAPAN, Band 7, Nr. 77, (C-159)[1222], 30. März 1983; & JP-A-58 6970
- PATENT ABSTRACTS OF JAPAN, Band 7, Nr. 155 )(C-175)[1300], 7. Juli 1983; & JP-A-58 67 858

## Beschreibung

Die Erfindung betrifft ein verfahren zur Herstellung von mehrlagigen CVD- oder PVD-Hartstoffschichten als Verschleißschutz auf WC-Co- oder WC-Ni-haltigen Hartmetallteilen, insbesondere Schneideinsätzen, wobei mindestens eine der Schichten eine Metall-Bornitrid-Schicht ist.

Bereits zu Beginn der kommerziellen Fertigung von Hartmetallteilen mit Hartstoffschichten, insbesondere von Schneideinsätzen bzw. Wendeschneidplatten, Anfang der 70er Jahre wurde in der Literatur auch die Verwendung von Boriden bzw. boridhaltigen Hartstoffen als Schichtwerkstoff vorgeschlagen, z.B. DE-OS 22 63 210. Aus der gleichen Zeit stammt die DE-OS 25 25 185, gemaß der auf einem Hartmetall-Grundkörper eine Zwischenschicht aus einem oder mehreren Boriden und darüber eine äußere Schicht aus Aluminium und/oder Zirkonoxyd aufgetragen wird. Die Borid-Zwischenschicht hat dort die Aufgabe, die Haftfestigkeit der oxydischen Deckschicht zu verbessern.

Boridschichten bzw. Boride enthaltende Schichten auf Hartmetall-Werkzeugen haben indes bis heute kaum praktische Bedeutung erlangt, obwohl die physikalischen und metallurgischen Eigenschaften der Boride, z.B. deren Härte, aber auch ihre Auftragbarkeit mittels CVD- und PVD-Technik eine Anwendung günstig erscheinen lassen mußten und obwohl - wie nachfolgend gezeigt wird - immer wieder versuche unternommen wurden, borhaltige Phasen zum oberflächlichen Verschleißschutz von Hartmetall-Verschleißteilen heranzuziehen.

In einer französischen Arbeit aus dem Jahr 1977 wird berichtet (J. L. Peytavy et. al, Vorabdrucke zum 9. PLANSEE Seminar 23. - 26.05.1977, Vol. II, s.1-13), Titan-Bornitride auf Hartmetall abzuscheiden. Eine 10 µm dick mit Titan-Bornitrid-Schicht versehene Hartmetall-Schneidplatte weist im Vergleich zu einer mit TiN-Schicht gleicher Schichtdicke versehene Hartmetall-Schneidplatte beim Drehen einer bestimmten Stahlsorte aufgrund geringeren Freiflächen-Verschleißes zwei- bis dreifache Standzeiten auf. Es fehlen dort jedoch Angaben zur Stoßbelastung der Testplatten (unterbrochener Schnitt). Nur eine entsprechend ergänzte Aussage ließe eine Bewertung zu, ob jene Testplatten auch ein aus heutiger Sicht gefordertes Mindestmaß an Zähigkeit aufweisen. Die CVD-Schichten wurden dort im Temperaturbereich zwischen 1150 und 1450°C erzeugt und waren überwiegend zweiphasig aufgebaut. Die zweiphasigen Schichten bestanden aus einer Mischung von Titandiborid und Titanbornitrid. Nach den dortigen Erkenntnissen setzt mit niedrigerer Abscheidetemperatur auch die Formation von Diboriden als zweite Phase neben dem Titanbornitrid - wahrscheinlich infolge geringerer Löslichkeit von Bor im Titannitrid - bereits bei niedrigerem Boranteil im Gesamtgasgemisch des CVD-Prozesses ein. In der Randzone der WC-Co-haltigen Hartmetalle wird eine spröde Wolfram-Kobalt-Borphase (WCoB-Phase) gebildet.

In der JP 58-67858 wird vorgeschlagen, auf einem Hartmetall-Verschleißteil mit einer ersten TiC-Zwischenschicht für die Schichthaftung eine Aluminium-Oxydschicht als verschleißhemmende Schicht aufzubringen, welche ihrerseits beidseitig mit einer Ti(B,N)-Schicht umgeben ist. Dort beträgt der Boranteil am Bornitrid 5 - 40 % Molenanteil, so daß die Ti(B,N)-Schicht zumindest vorzugsweise zweiphasig als Ti-Diborid- und Ti-Bornitrid-Schicht auftritt. Die Boride dienen zur Verbesserung der Schichthaftung. Die Verhinderung der Bildung von spröden WCoB-beziehungsweise WNiB-Phasen in der Hartmetall-Randzone, durch eine Diffusionsbarriere zwischen Substrat und Ti(B,N)-Schicht, ist nicht erwährt.

In der US-PS 4 239 536 wird ein beschichteter Hartmetallkörper beschrieben, der mindestens eine Schicht aus Metall-Bornitriden und Borkarbonitriden der Elemente der 4. - 6. Nebengruppe des Periodensystems aufweist.
Die Eigenschaften der Diboride, insbesondere ihre große Härte noch bei ca. 1000°C Anwendungstemperatur, werden erwähnt und sollen bei Schneideinsätzen für die Zerspanung besondere Verschleißvorteile bringen. Da Diboride andererseits bei den üblicherweise hohen Schnittemperaturen wesentlich stärker mit Eisenwerkstoffen reagieren als Nitride, wird die Auftragung einer Borid-Nitrid-Mischphase mit maximal 50 % Bor-Molanteil vorgeschlagen. Im Patent wird durch vergleichende Untersuchungen belegt, daß Schneideinsätze mit zweiphasigen Schichten (Ti(B,N) + TiB₂) eine längere Lebensdauer aufweisen als einphasige (Ti(B,N) und daß optimale Standzeiten bei 30 - 40 % TiB₂-Anteil in einer Boridnitrid-Schicht erreicht werden. Die Bildung einer WCoB-Randzone im WC-Co-hältigen Hartmetall erfolgt dort unausweichlich.

Zemann et.al berichteten auf dem PLANSEE Seminar 1981 (Proceedings of the 10th PLANSEE Seminar 1981, Vol. 1, Seiten 443ff) über die Abscheidung von TiB₂-Schichten aus der Gasphase auf Hartmetall. Die Abscheidung erfolgte im Temperaturbereich 700 - 1070°C unter Verwendung von BBr₃ zur Einbringung des Bors. Es wurden sehr unterschiedliche Abscheideraten und Schichtstrukturen je nach den gewählten Beschichtungsbedingungen, insbesondere Abscheidetemperatur, erzielt. Dabei wurden die älteren Beobachtungen bestätigt, wonach Bor bei den genannten Beschichtungstemperaturen, mit Wolfram-Kobalt-Hartmetall in Kontakt gebracht, zur Ausbildung einer spröden Wolfram-Kobalt-Borphase führt. Im Falle der Beschichtung von Wolframkarbid-Kobalt-Hartmetall mit Diboriden läßt sich aufgrund der dort gemachten Erfahrung die Ausbildung der Wolfram-Kobalt-Borphase in der Hartmetall-Randzone durch vorherige Auftragung einer Titankarbid-Zwischenschicht vermeiden.

In der DE-OS 33 32 260 wird ein Verfahren beschrieben, nach dem sich die vorgenannte Wolfram-Kobalt-Borphase in der Randzone von WC/Co-Hartmetall besonders wirtschaftlich herstellen läßt. Ein WC/Co-Hartmetall-Grundkörper wird vor der Abscheidung von Oxydhartstoffschichten oberflächlich boriert, so daß in einer Randzone des Hartmetalls die harte und spröde Wolfram-Kobalt-Borphase entsteht. Die Ausbildung dieser Phase ist erwünscht, weil sie die Haftfestigkeit der anschließend aufgetragenen Oxydschicht auf dem Substratmaterial wesentlich erhöht und die Verschleißfestigkeit insgesamt erhöht.

Weiterhin ist in der EP-A-0 015 451 ein beschichteter Hartmetall-Gegenstand beschrieben, wobei zunächst aufgrund geeigneter Maßnahmen durch die Oberfläche Bor, Silizium oder Aluminium in das Hartmetallsubstrat eindiffundiert. Auf das so präparierte Substrat werden zunächst eine oder mehrere Schichten aus Karbiden, Nitriden oder Karbonitriden und schließlich als Deckschicht eine Lage aus Titan-, Hafnium-, Zirkon- oder Tantalborid bzw. -diborid aufgetragen.

Daneben wird gemäß der US-Patentschrift 4 236 926 eine wesentliche Verschleißfestigkeits-Steigerung von Hartmetallen allein durch Borieren ohne zusätzliche Beschichtung erreicht. Im Temperaturbereich zwischen 715 und 1000°C wird das Hartmetall einer Gasmischung aus Bortrihalogeniden und Wasserstoffhalogeniden ausgesetzt, um dadurch eine Borierung und Reaktion der Hartmetall-Randzone im Bereich zwischen 1 und 100 µm zu erzielen.

Unter der Vielzahl von Veröffentlichungen zum Stand der Technik, bei denen Bor als Schichtkomponente auf unterschiedlichen Substraten genannt ist, sind zu erwähnen,
die AT-PS 377 786, bei welcher Aluminiumoxidschichten mit kleinen Gehalten an Bor als Verschleißschutzschicht auf Hartmetallteilen aufgetragen wird,
weiterhin die DD-PS 225 454, nach der ein Verfahren zur Herstellung von Boridschichten auf Eisenwerkstoffen mittels eines Borierungsverfahrens beschrieben ist,
weiterhin die DE-OS 35 02 262, nach der ein Verfahren zum Herstellen einer borhaltigen Gasatmosphäre beschrieben ist, wobei entsprechende Gasmischungen zur Herstellung von borhaltigen Schichten nach dem PVD- und CVD-Verfahren grundsätzlich anwendbar sind
und schließlich die JP-OS 61-177372, welche ein besonders wirtschaftliches Verfahren zur Herstellung von Bornitridfilmen zum Inhalt hat.

Der vorstehende Abriß zum Stand der Technik belegt, daß vielfältige Versuche unternommen wurden, um Boride als Hartstoffe für Verschleißschutzschichten auf Hartmetallteilen nutzbar zu machen. Die Unterschiedlichkeit der angewandten Beschichtungsbedingungen mit häufig entgegengesetzter Zielrichtung bezüglich Struktur, Stoffaufbau und Schichtfolge der Werkstoffe läßt indes erkennen, daß hinsichtlich der vorteilhaften Nutzung von Boriden als Verschleißschutz auf Hartmetallwerkzeugen bis heute keine gesicherte Fachmeinung besteht. Vielmehr sind Erzeugnisse der vorbeschriebenen Art bis heute nicht oder nicht in nennenswertem Umfang kommerziell verfügbar - etwa im Unterschied zu karbid- und/oder nitridbeschichteten Hartmetall-Schneideinsätzen, welche heute in weiten Anwendungsbereichen der Zerspanung regelmäßig verwendet werden. Offensichtlich läßt sich bisher eine für derartige Erzeugnisse in Summe geforderte Mindestqualität, insbesondere was die Anforderungen an die Zähigkeit betrifft, nicht erreichen.

Die Aufgabe vorliegender Erfindung besteht somit darin, unter Verwendung von Boridhartstoffen die Verschleißfestigkeit von WC-Co- oder WC-Ni-haltigen Hartmetall-Verschleißteilen mit Hartstoffschichten, insbesondere von Schneideinsätzen, zu verbessern. Die Aufgabe besteht insbesondere darin, die guten Verschleißeigenschaften der Nitride in Hartstoffschichten weitgehend zu erhalten und deren wesentliche Nachteile, die vergleichsweise geringe Eigenhärte und Warmhärte, sowie die nachteilige Stengel-Schichtstruktur bei dickeren TiN-Schichten durch Borzusätze zu den Schichten zu überwinden, und zugleich den Versprödungseffekt durch übermäßige Eindiffusion von Bor ins Hartmetall-Substrat zu vermeiden.

Die Aufgabe wird erfindungsgemäß durch die in Anspruch 1 genannten Merkmale gelöst. Bevorzugte Ausführungsformen sind in den Unteransprüchen 2-10 offenbart.

Zur Ausbildung von Metall-Bornitriden eignen sich die Metalle der 4. und 5. Nebengruppe des Periodensystems, einzeln oder in Mischungen. Diese Metalle werden bekanntermaßen auch zur Herstellung von reinen Nitrid- bzw. Karbonitrid-Hartstoffschichten verwendet.

Neben den Metallen der 4. und 5. Nebengruppe können auch andere Metalle, insbesondere Aluminium oder Aluminium gemeinsam mit anderen Elementen, wie Vanadium, in kleineren Anteilen vorhanden sein. Beispielsweise hat sich eine Titanbornitrid-Schicht mit bis zu 25 Atom% Aluminium oder mit 6 Gew.% Aluminium und 4 Gew.% Vanadium bewährt.

Die für die Ausbildung einer einphasigen Metallbornitrid-Schicht einzuhaltende Obergrenze an Borgehalt ist für unterschiedliche Schichtwerkstoffe und Abscheidebedingungen sehr verschieden. Im Falle einer Titanbornitrid-Schicht wird der Borgehalt zwischen 1 und 20 Atom%, vorzugsweise 1,5 - 15 Atom%, liegen. Demgegenüber liegen die vorteilhaften Borgehalte bei der Ausbildung von Zirkon-Bornitrid-Schichten im Bereich zwischen 0,05 und 5 Atom% Bor, vorzugsweise 0,1 - 2 Atom% Bor.
Die einphasige Metall-Bornitrid-Schicht kann auch als Karbonitrid vorliegen, und zwar bevorzugt als stickstoffreiches Karbobornitrid mit Kohlenstoffanteilen ≦ 50 % des Stickstoffanteiles. Desweiteren können die Metall-Bornitrid-Schichten kleine Anteile an Sauerstoff aufweisen.
Die Metall-Bornitrid-Schichten werden vorzugsweise nach dem CVD-Verfahren bei Temperaturen unterhalb von 1050°C abgeschieden.

Die Metall-Bornitrid-Schichten können entweder einlagig oder mehrlagig abgeschieden werden. Im letzteren Fall erfolgt die Abscheidung auf die Zwischenschicht, wobei die Metall-Bornitrid-Schichten mit reinen Nitrid- oder Karbonitrid-Schichten abwechseln und die Nitrid- oder Karbonitrid-Schichten ihrerseits sauerstoffhältig sein können und dann als sogenannte Oxynitrid- oder Oxykarbonitrid-Schichten vorliegen. Ebenso können die Nitrid- oder Karbonitrid-Schichten auch kleine Borgehalte aufweisen, wobei diese aber wesentlich unter den Borgehalten der Metall-Bornitrid-Schichten liegen müssen. Bei einlagigen Metall-Bornitrid-Schichten liegt die Schichtdicke vorzugsweise zwischen 1 und 10 µm, bei mehrlagiger Anordnung sind für den Schichtverbund aus Metall-Bornitrid im Wechsel mit Nitrid- bzw. Karbonitrid-Schichten Gesamtschichtdicken zwischen 1 und 20 µm, vorzugsweise zwischen 2 und 12 µm vorteilhaft.

Nach einer bevorzugten Ausgestaltung des Verfahrens wird eine Mehrzahl von Metall-Bornitrid-Schichten von jeweils 0,5 - 3 µm Dicke im Wechsel mit reinen Nitrid- oder Karbonitrid-Schichten von jeweils 0,1 - 1 µm Dicke abgeschieden. Dieser Wechsel zwischen den einzelnen Schichten kann 2 - 3, aber auch 7 - 8 mal oder noch öfter erfolgen.

Für die Zwischenschicht zwischen Hartmetall-Substrat und Metall-Bornitrid-Schicht haben sich Karbide, Nitride und Karbonitride der 4. - 6. Nebengruppe des Periodensystems, aber auch Metall-Bornitride der Elemente der 4. und 5. Nebengruppe des Periodensystems mit wesentlich niedrigerem Borgehalt als in der nachfolgenden Metall-Bornitrid-Schicht bewährt. Die Zwischenschicht kann ein- oder mehrlagig ausgeführt sein und Schichtdicken zwischen 1 und 10 µm, vorzugsweise von 2 - 6 µm, aufweisen.

Bei einer mehrlagigen Ausführung der Zwischenschicht können auch Oxykarbide, Oxynitride und Oxykarbonitride in die Zwischenschicht eingebaut sein.

Selbstverständlich schließt die vorliegende Erfindung auch Ausführungen mit ein, wo neben den genannten Metall-Bornitrid- und vorgenannten Zwischenschichten eine Oxydschicht bzw. überwiegend Oxyde aufweisende Schicht eingebaut ist, z. B. Al₂O₃, ZrO₂, AlON, B₂O₃-haltige Al₂O₃-Schicht. Derartige Schichten können in einzelnen Fällen, insbesondere bei speziellen zu zerspanenden Werkstoffen zusätzliche Verbesserungen erbringen.

Ebenso ist es selbstverständlich, daß die, bzw. eine Metall-Bornitrid-Schicht nicht in der obersten Lage des Schichtverbundes angeordnet sein muß, sondern daß darüber noch ein oder mehrere andersartige Hartstoffschichten beliebiger Zusammensetzung angeordnet sein können.

Im Unterschied zu allen Vorveröffentlichungen, wo die Verfahren und danach erzeugte Verschleißteile stets darauf ausgerichtet waren, die Stoffeigenschaften der reinen harten Boridphasen zu nutzen und wo alternativ oder ergänzend auch die Ausbildung von harten aber relativ spröden WCoB-Phasen einen wirkungsvollen Verschleißschutz geben soll, zeigt die vorliegende Erfindung überraschenderweise, daß schon die Ausbildung einer einphasigen homogenen Bornitrid-Mischkristallphase auf einer Zwischenschicht eine wesentliche Verschleißfestigkeits-Steigerung, insbesondere des Freiflächen-Verschleißes von Schneideinsätzen bewirkt. Eine für weite Anwendungsbereiche ausreichende Zähigkeit des Verbundes Hartmetall und Schicht sowie Elastizität und Haftfestigkeit von boridhaltigen Schichten läßt sich nur in der Ausgestaltung gemäß vorliegender Erfindung erzielen. Die erfindungsgemäßen Schichten zeichnen sich durch überraschende Feinkörnigkeit und geringe Stengelstruktur-Bildung aus.
Im Vergleich zu reinen Titannitrid- oder Titankarbonitrid-Schichten lassen sich wesentlich größere Schichtdicken bei vergleichbarer Schichtelastizitat und ohne die Gefahr von Rissen in der Schicht ausbilden. Die Oberflächenrauhigkeit ist im Vergleich mit reinen Nitrid- und Metall-Bornitrid-Schichten wesentlich verringert.

Durch die Obergrenze des Borgehalts wird im Zusammenwirken mit einer Zwischenschicht und einer geeigneten Beschichtungstemperatur die Bordiffusion im Hartmetall-Verschleißteil so weit herabgesetzt, daß keine Versprödung der Randzone des Hartmetall-Substrates auftritt.

Wesentlich für die Beschichtungstemperatur ist, daß sie möglichst niedrig liegt und beim CVD-Verfahren einen Wert von 1050°C nicht übersteigt.

Weiters zeigt sich überraschenderweise, daß bei einer mehrlagigen Anordnung von TiN und/oder Ti(C,N) im Wechsel mit Ti(B,N) und/oder Ti(B,N,C) Schichten eine zusätzliche Steigerung der Kolkfestigkeit erreicht und zugleich die Freiflächen-Verschleißfestigkeit einlagiger Metall-Bornitrid-Schichten unverändert erhalten bleibt.

Unter der Definition WC-Co-haltige bzw. WC-Ni-haltige Hartmetallteile als Substratmaterialien ist zu verstehen, daß zumindest ein geringer Anteil an WC und Co und/oder Ni in der Hartmetall-Zusammensetzung enthalten ist. Inwieweit daneben noch weitere Hartstoffanteile und Bindemetall-Legierungselemente im Hartmetall enthalten sind, ist für das erfindungsgemäße Beschichtungsverfahren von untergeordneter Bedeutung.

Die Erfindung wird anhand nachfolgender Beispiele näher beschrieben:

### Beispiel 1

Eine Hartmetall-Wendeschneidplatte der Sorte 2,5 Gew.% TiC, 5,5 Gew.% Ta(Nb)C, 6 Gew.% Co, Rest WC, und der Form SPGN 120308 EN wurde zur Beschichtung nach dem CVD-Verfahren in einen Rezipienten eingebaut, unter Schutzgas aufgeheizt und unter Normaldruck bei einer Beschichtungstemperatur von 1030°C mit folgenden Gaszusammensetzungen und Beschichtungszeiten beschichtet:
1. 77,6 Vol.% H₂
   2,7 Vol.% TiCl₄
   8,4 Vol.% CH₄
   11,3 Vol.% Ar
   Beschichtungszeit: 35 min.
2. 77,1 - 70,2 Vol.% H₂
   2,6 - 2,4 Vol.% TiCl₄
   2,8 - 15,3 Vol.% N₂
   6,3 - 1,9 Vol.% CH₄
   11,2 - 10,2 Vol.% Ar
   wobei dieser Beschichtungszyklus in vier Stufen erfolgte, die erste und vierte Stufe mit den jeweils angegebenen Grenzwerten und die zweite und dritte Stufe mit dazwischenliegenden Werten.
   Beschichtungszeit für Stufe 1 - 3: jeweils 16 min.
   Beschichtungszeit für Stufe 4: 12 min.
3. 51,4 Vol.% H₂
   1,76 Vol.% TiCl₄
   46,7 Vol.% N₂
   0,14 Vol.% BCl₃
   Beschichtungszeit: 55 min.

Die anschließende metallographische Schichtprüfung ergab folgenden Schichtaufbau: auf das Hartmetall-Substrat folgte zunächst eine 3 µm dicke TiC und dann eine 4 µm dicke Ti(C,N)-Schicht, welche ihrerseits in vier Schichtbereiche, mit nach außen steigender N- und fallender C-Konzentration unterteilt war. Den Abschluß bildet eine 6 µm dicke Ti(N,B)-Schicht mit einem Borgehalt von 5,5 Atom% und einer Korngröße < 1 µm, im Mittel ca. 0,5 µm.

Zum Vergleich mit der Wendeschneidplatte gemäß Erfindung wurde eine gleichartig aufgebaute und beschichtete Wendeschneidplatte herangezogen, jedoch mit dem einen wesentlichen Unterschied, daß die äußere Schicht keine Titan-Bornitrid-, sondern eine reine Titannitrid-Schicht war, die ca. 5 µm lange und ca. 2 µm dicke Säulen aufwies.

Die Beschichtung dieser Wendeschneidplatte erfolgte unter den gleichen Beschichtungsbedingungen wie die Beschichtung der erfindungsgemäß beschichteten Wendeschneidplatte, lediglich die dritte Gaszusammensetzung war folgendermaßen geändert:
51,4 Vol.% H₂
1,8 Vol.% TiCl₄
46,8 Vol.% N₂
Beide Wendeschneidplatten wurden anschließend einer vergleichenden Zerspanungsprüfung unterzogen. Mit den Wendeschneidplatten wurde Baustahl der Sorte Ck 45 und einer Festigkeit von 700 N/mm² durch Drehen unter den folgenden Bedingungen bearbeitet:
Schnittgeschwindigkeit: 220 m/min
Vorschub: 0,3 mm/U
Spantiefe: 2 mm

| Verschleißteil | Drehzeit | Verschleißmarkenbreite |
|---|---|---|
| Vergleichsausführung (TiN) | 12 min | 0,20 mm |
| Ausführung gemäß Erfindung (Ti(N,B) | 12 min | 0,13 mm |
| | 24 min | 0,18 mm |

Die Ausführung gemäß Erfindung wies nach 24 Minuten Drehzeit einen Freiflächenverschleiß mit einer Verschleißmarkenbreite von 0,18 mm auf, während die Vergleichsausführung bereits nach 12 Minuten einen höheren Wert aufwies mit einer Verschleißmarkenbreite für den Freiflächenverschleiß von 0,2 mm.

### Beispiel 2

Dieses Beispiel zeigt die Qualität einer Wendeschneidplatte gemäß vorliegender Erfindung im Vergleich mit einer solchen, bei welcher keine Zwischenschicht zwischen Substrat und Metall-Bornitrid-Schicht vorliegt und somit nicht der Ausführung gemäß vorliegender Erfindung entspricht. Für die Ausführung gemäß vorliegender Erfindung sowie die Vergleichsausführung wurden jeweils in einer Variante 2a eine Hartmetallsorte mit 0,2 Gew.% TiC, 0,4 Gew.% Ta(Nb)C, 6 Gew.% Co und der Rest WC in der geometrischen Form SPGN 120308 EN und einer Variante 2b eine Hartmetallsorte mit 6 Gew.% Ni, 0,3 Gew.% Cr₃C₂ und 0,3 Gew.% Mo und der Rest WC in der gleichen geometrischen Form verwendet.
Die Beschichtung erfolgte bei beiden Varianten in einer CVD-Anlage bei 1000°C und Normaldruck mit folgenden Gaszusammensetzungen:
erfindungsgemäße Ausführung:
1. 69,44 Vol.% H₂
   0,80 Vol.% TiCl₄
   29,76 Vol.% N₂
   Beschichtungszeit: 15 min.
2. 69,13 Vol.% H₂
   0,80 Vol.% TiCl₄
   29,63 Vol.% N₂
   0,44 Vol.% BCl₃
   Beschichtungszeit: 60 min.

### Vergleichsausführung:

69,13 Vol.% H₂
0,80 Vol.% TiCl₄
29,63 Vol.% N₂
0,44 Vol.% BCl₃
Beschichtungszeit: 85 min.

Die anschließende metallographische Schichtuntersuchung für Variante 2a ergab, daß in der Ausführung gemäß Erfindung angrenzend an das Hartmetall eine 2,5 µm dicke TiN- und darüber eine 2,5 - 3 µm dicke Ti(N,B)-Schicht aufgebracht war. In der Randzone des Hartmetalls waren WCoB- und WCoC-Phasenbereiche von durchschnittlich 1 µm Dicke, vereinzelt bis 3 µm Dicke sichtbar. Bei der erfindungsgemäßen Ausführung nach Variante 2b ergab die metallographische Schichtuntersuchung angrenzend an das Hartmetall denselben Schichtaufbau, während in der Randzone des Hartmetalles WNiC- und WNiB-Phasen von ca. 1 µm Dicke sichtbar waren.

Bei den Vergleichsausführungen zeigte die metallographische Schichtuntersuchung eine einlagige, 5 - 6 µm dicke Ti(B,N)-Schicht. In der Randzone des Hartmetalls wurden bei Variante 2a Bereiche mit WCoC- und WCoB-Phasen von bis zu 5 µm Dicke und bei Variante 2b WNiC- und WNiB-Phasen von bis zu 4 µm Dicke festgestellt.

Für den anschließenden Zerspanungstest bzw. für eine Zerspanungs-Zähigkeitsprüfung wurde eine Prüfvorrichtung verwendet, welche aus einem Zylinder von 230 mm Durchmesser bestand, auf den vier Stück Leisten mit rechteckigem Querschnitt und einer Breite von 60 mm Leistenbreite aufgespannt waren. Als Leistenwerkstoff diente ein Stahl der Type VEW W 300, auf eine Festigkeit von 800 N/mm² vergütet.
Zu Testzwecken wurde bei einer Schnittgeschwindigkeit von 150 m/min und einer Spantiefe von 2 mm der Vorschub solange gesteigert, bis ein Schneidkantenbruch bei der getesteten Wendeschneidplatte eintrat.
Bei Variante 2a fiel die nur mit einer Ti(B,N)-Schicht belegte Vergleichsplatte bei einem Vorschub von 0,34 mm/U durch Bruch aus, während die erfindungsgemäß beschichtete Wendeschneidplatte bis zu einem Vorschub von 0,43 mm/U standhielt. Bei Variante 2b fiel die nur mit Ti(B,N) beschichtete Vergleichsplatte bereits bei einem Vorschub von 0,26 mm/U durch Bruch aus, während die erfindungsgemäß beschichtete Platte einen Vorschub von 0,36 mm/U erreichte.

Der Vergleichsversuch belegt, daß zur Erreichung der Zähigkeiten, wie sie bei modernen Schneidwerkstoffen erwartet werden, das Eindiffundieren von Bor in die Hartmetall-Randzone durch Aufbringen einer geeigneten Zwischenschicht sowie durch entsprechende Anpassung der Beschichtungstemperatur für die Metall-Bornitrid-Schicht unterbunden bzw. auf ein niedriges Grenzmaß herabgesetzt werden muß.

### Beispiel 3

Dieses Beispiel zeigt die Unterschiede im Verschleißverhalten von Wendeschneidplatten gleicher Hartmetall-Zusammensetzung, gleicher Form und gleicher Zwischenschicht, wenn eine einlagige Ti(N,B)-Schicht auf der Zwischenschicht durch eine mehrlagige Ti(N,B)-Schicht ersetzt wird. Hartmetallsorte und geometrische Form der beiden Vergleichsausführungen entsprechen den Ausführungen nach Beispiel 1.

Die Beschichtung erfolgte in einer CVD-Anlage bei einer Beschichtungstemperatur von 1030°C unter Normaldruck mit folgenden Gaszusammensetzungen und Beschichtungszeiten:

### Ausführung mit mehrlagiger Ti(N,B)-Schicht:

1. 77,6 Vol.% H₂
   2,7 Vol.% TiCl₄
   8,4 Vol.% CH₄
   11,3 Vol.% Ar
   Beschichtungszeit: 38 min.
2. 77,1 - 70,2 Vol.% H₂
   2,6 - 2,4 Vol.% TiCl₄
   2,8 - 15,3 Vol.% N₂
   6,3 - 1,9 Vol.% CH₄
   11,2 - 10,2 Vol.% Ar
   wobei dieser Beschichtungszyklus in vier Stufen erfolgte, die erste und vierte Stufe mit den jeweils angegebenen Grenzwerten und die zweite und dritte Stufe mit dazwischenliegenden Werten.
   Beschichtungszeit für Stufe 1 - 3: jeweils 12 min.
   Beschichtungszeit für Stufe 4: 10 min.
3. 53,2 Vol.% H₂
   2,4 Vol.% TiCl₄
   44,4 Vol.% N₂
   Beschichtungszeiten: 2 min., 1 min., 1 min., 3 min.
4. 53,2 Vol.% H₂
   2,37 Vol.% TiCl₄
   44,3 Vol.% N₂
   0,13 Vol.% BCl₃
   Beschichtungszeiten: 17 min., 17 min., 17 min.
   wobei mit den Gaszusammensetzungen 3. und 4. wechselweise mit den angegebenen Zeiten beschichtet wurde.

### Metallographisch wurde folgender Schichtaufbau gefunden:

3 µm TiC
3 µm Ti(C,N) (bestehend aus vier Lagen mit unterschiedlichem C- und N-Anteil, N nach außen steigend)
6 µm Ti(N,B) und TiN mit folgender Anordnung:
0,3 µm TiN
1,6 µm Ti(N,B)
0,2 µm TiN
1,6 µm Ti(N,B)
0,2 µm TiN
1,6 µm Ti(N,B)
0,4 µm TiN
Ausführung mit einlagiger Ti(N,B)-Schicht:
Gaszusammensetzung 1. und 2. und entsprechende Beschichtungszeiten gleich wie bei der mehrlagigen Ausführung
3. 53,2 Vol.% H₂
   2,37 Vol.% TiCl₄
   44,3 Vol.% N₂
   0,13 Vol.% BCl₃
   Beschichtungszeit: 58 min.

Metallographisch wurde folgender Schichtaufbau gefunden:
3 µm TiC
3 µm Ti(C,N) (vier Lagen mit unterschiedlichem C- und N-Anteil, N nach
außen steigend) 6 µm Ti(N,B)
REM-Bruchaufnahmen zeigten beim mehrlagigen Ti(N,B)-Schichtaufbau eine gegenüber dem einlagigen Ti(N,B)-Schichtaufbau wesentlich gleichmäßigere und feinere Struktur.

Die Zerspanungsprüfung erfolgte durch Längsdrehen auf einer glatten Baustahlwelle.

Ck 60 Festigkeit: 870 N/mm² mit den folgenden Schnittbedingungen:
Schnittgeschwindigkeit: 140 m/min
Vorschub 0,41 mm/U
Spantiefe: 2 mm

| Schichtart | Schnittdauer | Freiflächenverschleiß | Kolkbreite |
|---|---|---|---|
| Ti(N,B) einlagig | 18 min | 0,18 mm | 0,20 mm |
| Ti(N,B) mehrlagig | 18 min | 0,18 mm | 0,14 mm |
| | 23,5 min | 0,19 mm | 0,20 mm |

Durch die mehrlagige Anordnung der Ti(N,B)- und TiN-Schichten erreicht man aufgrund der verbesserten Kolkfestigkeit eine Standzeiterhöhung um 30 %.

### Beispiel 4

Dieses Beispiel zeigt die Unterschiede im Verschleißverhalten zwischen einer Wendeschneidplatte mit einem Schichtaufbau entsprechend der Ausführung mit mehrlagiger Ti(N,B)-Schicht entsprechend Beispiel 3 und einer Wendeschneidplatte mit einer einlagigen TiN-Schicht auf derselben TiC-Ti(C,N)-Zwischenschicht bei der Bearbeitung von Gußwerkstoffen.

Die Beschichtung der Wendeschneidplatte mit der mehrlagigen Ti(N,B)-Schicht erfolgte unter den gleichen Bedingungen wie bei Beispiel 3, ebenso die Beschichtung der Zwischenschicht der Vergleichsausführung.

Gaszusammensetzung zur Abscheidung der TiN-Schicht:
53,2 Vol.% H₂
2,4 Vol.% TiCl₄
44,4 Vol.% N₂
Beschichtungszeit: 58 min.
Bei diesen Bedingungen wurde eine 6 µm dicke TiN-Schicht abgeschieden.

Die Zerspanungsprüfung erfolgte durch Längsdrehen einer Mildhartgußwelle mit einer Härte von 200 HB unter folgenden Schnittbedingungen:
Schnittgeschwindigkeit: 120 m/min.
Vorschub: 0,36 mm/U
Spantiefe: 2 mm

| Schichtart | Schnittdauer | Freiflächenverschleiß |
|---|---|---|
| Ti(N,B) mehrlagig | 10 min | 0,14 mm |
| TiN | 10 min | 0,23 mm |

Der Freiflächenverschleiß war bei der Variante mit der mehrlagigen Ti(N,B)-Schicht um 39 % niedriger als bei einer TiN-Schicht als oberste Lage. Aus diesem Drehversuch geht hervor, daß durch den Einbau von Titanbornitrid auch bei der Zerspanung von Gußwerkstoffen wesentliche Verschleißfestigkeits-Verbesserungen erreicht werden.

### Beispiel 5

Bei diesem Beispiel wird eine einlagige TiN-Schicht mit einer zweilagigen Schicht, bestehend aus TiN-Ti(N,B) jeweils abgeschieden mit dem PVD-Verfahren Magnetron-Sputtern, verglichen.

Wendeschneidplatten der Form SNUN 120408 EN und einer Sorte bestehend aus 6 % Kobalt, 2,5 % TiC, 5,5 % Ta(Nb)C, Rest WC, wurden in eine Labor-SputterAnlage eingebaut. In dieser befanden sich zwei Targets, und zwar eines aus reinem TiN und ein zweites aus Ti-Bornitrid mit 8 Atom-% Bor. Nach dem üblichen Sputterätzen zur Reinigung der Substrate wurde zunächst mit dem TiN-Target eine 3 µm dicke TiN-Schicht abgeschieden und anschließend eine 7 µm dicke Ti(N,B)-Schicht mit dem Ti-Bornitrid-Target, wobei jeweils eine DC-Magnetron-Entladung angewandt wurde.
Es wurden folgende weitere Beschichtungsbedingungen eingestellt:
Leistung: 800 Watt
Argondruck: 8 x 10⁻³ mbar
BIAS-Spannung an den Substraten: -800 Volt
Beschichtungsdauer mit dem TiN-Target: 15 Minuten
Beschichtungsdauer mit dem Ti(N,B)-Target: 35 Minuten
Die ungekühlten Substrate erreichten jeweils eine Temperatur von ca. 450°C.
Der Übergang vom TiN-Target zum Ti(N,B)-Target erfolgte unter Beibehaltung der BIAS-Spannung auf den Substraten und kurzem Sputterätzen vor dem Aufbringen der Ti(N,B)-Schicht.

Auf der Spanfläche der Wendeschneidplatten hat sich eine Schicht von ca. 3 µm TiN, gefolgt von 7 µm Titan-Bornitrid mit ca. 7 Atom-% Bor abgeschieden.

Zum Vergleich wurden in einem zweiten Versuch Wendeschneidplatten nur mit 10 µm TiN beschichtet, mit den gleichen Bedingungen. Die Titan-Bornitrid-Schicht zeichnet sich im Vergleich zur TiN-Schicht durch eine wesentlich feinere Struktur aus.

Beide Wendeschneidplatten wurden abschließend wieder einer vergleichenden Zerspanungsprüfung unterzogen, und zwar durch einen Drehversuch auf Baustahl der Sorte Ck 60 und einer Festigkeit von 870 N/mm².
Schnittgeschwindigkeit: 160 m/min
Vorschub: 0,41 mm/U
Spantiefe: 2 mm
Die nur mit TiN beschichtete Platte wies nach 20 min Drehdauer eine Freiflächenverschleißmarkenbreite von 0,5 mm auf, während mit der mit TiN und Ti(N,B) beschichteten Platte der gleiche Verschleiß erst nach 36 min Drehzeit vorlag.

Es zeigte sich, daß eine signifikante Verbesserung des Freiflächenverschleißes auch bei der Abscheidung des erfindungsgemäßen Schichtaufbaues mit PVD-Verfahren eintritt.

## Patentansprüche

1. Verfahren zur Herstellung von mehrlagigen CVD- oder PVD-Hartstoffschichten als Verschleißschutz auf WC-Co- oder WC-Ni-haltigen Hartmetallteilen, z. B. Schneideinsätzen, wobei mindestens eine der Schichten eine Metall-Bornitrid-Schicht ist,
**dadurch gekennzeichnet,**
daß die Borkonzentration in der Metall-Bornitrid-Schicht unterhalb des Grenzwertes gehalten wird, bei welchem neben der homogenen Bornitrid-Mischkristallphase eine Diborid-Phase auftritt, und daß mittels Aufbringens einer nicht borhaltigen Zwischenschicht als Diffusionsbarriere zwischen Hartmetall und Metall-Bornitrid-Schicht die Formation von WCoB- bzw. WNiB-Phasen in der Randzone des Hartmetalles verhindert wird.

2. Verfahren zur Herstellung von Hartstoffschichten nach Anspruch 1, dadurch gekennzeichnet, daß eine Ti(B,N)-Schicht mit Borkonzentration zwischen 1 und 20 Atom%, vorzugsweise zwischen 1,5 und 15 Atom% erzeugt wird.

3. Verfahren zur Herstellung von Hartstoffschichten nach Anspruch 1, dadurch gekennzeichnet, daß eine Zr(B,N)-Schicht mit Borkonzentration zwischen 0,05 und 5 Atom%, vorzugsweise zwischen 0,1 und 2 Atom% erzeugt wird.

4. Verfahren zur Herstellung von Hartstoffschichten nach Anspruch 1 - 3, dadurch gekennzeichnet, daß das Bornitrid kohlenstoffhältig ist, vorzugsweise in Form von stickstoffreichen Karbonitriden mit Kohlenstoffanteilen ≦ 50 % des Stickstoffes.

5. Verfahren zur Herstellung von Hartstoffschichten nach Anspruch 1 - 4, dadurch gekennzeichnet, daß die Zwischenschicht als ein- oder mehrlagige Schicht aus einem Karbid, Nitrid oder Karbonitrid der Elemente Ti, Zr, Hf mit Schichtdicken zwischen 1 und 10 µm, vorzugsweise 2 und 6 µm gebildet wird.

6. Verfahren zur Herstellung von Hartstoffschichten nach Anspruch 1, dadurch gekennzeichnet, daß die Metall-Bornitrid-Schicht nach dem CVD-Verfahren bei Temperaturen unterhalb von 1050°C abgeschieden wird.

7. Verfahren zur Herstellung von Hartstoffschichten nach Anspruch 1 - 6, dadurch gekennzeichnet, daß eine einlagige Bornitrid-Schicht von 1 - 10 µm Dicke abgeschieden wird.

8. Verfahren zur Herstellung von Hartstoffschichten nach Anspruch 1 - 6, dadurch gekennzeichnet, daß auf die Zwischenschicht eine Mehrzahl von Bornitrid-Schichten von jeweils 0,5 - 3 µm Dicke jeweils im Wechzel mit reinen Nitrid- oder Karbonitridschichten von jeweils 0,1 - 1 µm Dicke abgeschieden wird.

9. Verfahren zur Herstellung von Hartstoffschichten nach Anspruch 1 - 6, dadurch gekennzeichnet, daß auf die Zwischenschicht eine Mehrzahl von Bornitrid-Schichten von jeweils 0,5 - 3 µm Dicke jeweils im Wechsel mit reinen Oxynitrid- oder Oxykarbonitridschichten von jeweils 0,1 - 1 µm Dicke abgeschieden wird.

10. Verfahren zur Herstellung von Hartstoffschichten nach Anspruch 8 - 9, dadurch gekennzeichnet, daß der auf die Zwischenschicht folgende Schichtverbund mit einer Gesamtschichtdicke zwischen 1 und 20 µm, vorzugsweise zwischen 2 und 12 µm abgeschieden wird.

## Claims

1. Process for the production of multilayer CVD or PVD hard material coats as protection against wear on WC-Co- or WC-Ni-containing hard metal parts, e.g. cutting inserts, whereby at least one of the coats is a metal boron nitride coat, characterised in that the boron concentration in the metal boron nitride coat is kept below the limit at which a diboride phase occurs in addition to the homogeneous boron nitride mixed crystal phase, and that, by means of applying a non-boron-containing intermediate coat as a diffusion barrier between hard metal and metal boron nitride coat, the formation of WCoB or WNiB phases in the surface region of the hard metal is prevented.

2. Process for the production of hard material coats according to claim 1, characterised in that a Ti(B,N) coat with a boron concentration of between 1 and 20 atom %, preferably between 1.5 and 15 atom %, is produced.

3. Process for the production of hard material coats according to claim 1, characterised in that a Zr(B,N) coat with a boron concentration of between 0.05 and 5 atom %, preferably between 0.1 and 2 atom %, is produced.

4. Process for the production of hard material coats according to claims 1 - 3, characterised in that the boron nitride is carbonaceous, preferably in the form of nitrogen-rich carbonitrides with carbon proportions ≦ 50 % of the nitrogen.

5. Process for the production of hard material coats according to claims 1 - 4, characterised in that the intermediate coat is formed as a single-layer or multilayer coat from a carbide, nitride or carbonitride of the elements Ti, Zr, Hf with coat thicknesses of between 1 and 10 µm, preferably 2 and 6 µm.

6. Process for the production of hard material coats according to claim 1, characterised in that the metal boron nitride coat is deposited by the CVD process at temperatures below 1050 °C.

7. Process for the production of hard material coats according to claims 1 - 6, characterised in that a single-layer boron nitride coat of 1 - 10 µm thickness is deposited.

8. Process for the production of hard material coats according to claims 1 - 6, characterised in that a number of boron nitride coats each of 0.5 - 3 µm thickness are deposited on the intermediate coat alternately with pure nitride or carbonitride coats each of 0.1 - 1 µm thickness.

9. Process for the production of hard material coats according to claims 1 - 6, characterised in that a number of boron nitride coats each of 0.5 - 3 µm thickness are deposited on the intermediate coat alternately with pure oxynitride or oxycarbonitride coats each of 0.1 - 1 µm thickness.

10. Process for the production of hard material coats according to claims 8 - 9, characterised in that the laminated coats following the intermediate coat are deposited with a total coat thickness of between 1 and 20 µm, preferably between 2 and 12 µm.

## Revendications

1. Procédé de fabrication, par dépôt chimique en phase vapeur (ou CVD), ou par dépôt physique en phase vapeur (ou PVD), de couches en matières dures en strates multiples servant à la protection contre l'usure sur des pièces en métaux durs contenant du WC-Co ou du WC-Ni, par exemple des plaquettes de coupe, au moins l'une des couches étant une couche en boronitrure métallique,
**caractérisé en ce que**
la concentration en bore dans la couche en boronitrure métallique est maintenue au-dessous de la valeur limite à laquelle une phase de diborure apparaît en plus de la phase cristalline homogène de mélange de boronitrure, et en ce que la formation de phases WCoB ou de WNiB dans la zone de bord du métal dur est empêchée par une application d'une couche intermédiaire sans teneur en bore comme barrière de diffusion entre le métal dur et la couche de boronitrure métallique.

2. Procédé de fabrication de couches en matières dures selon la revendication 1, caractérisé par la formation d'une couche en Ti(B,N) dont la concentration atomique en bore est comprise entre 1 et 20%, de préférence entre 1,5 et 15%.

3. Procédé de fabrication de couches en matières dures selon la revendication 1, caractérisé par la formation d'une couche en Zr(B,N) dont la concentration atomique en bore est comprise entre 0,05 et 5%, de préférence entre 0,1 et 2%.

4. Procédé de fabrication de couches en matières dures selon l'une des revendications 1 à 3, caractérisé en ce que le nitrure de bore contient du carbone, de préférence sous forme de carbonitrures riches en azote dans lesquels les proportions de carbone ≦ 50% de l'azote.

5. Procédé de fabrication de couches en matières dures selon l'une des revendications 1 à 4, caractérisé en ce que la couche intermédiaire est réalisée sous forme d'une couche à une ou plusieurs strates en carbure, nitrure ou carbonitrure des éléments Ti, Zr, Hf, les épaisseurs de couches étant comprises entre 1 et 10 µm, de préférence entre 2 et 6 µm.

6. Procédé de fabrication de couches en matières dures selon la revendication 1, caractérisé en ce que la couche en boronitrure métallique est déposée selon un procédé de dépôt chimique en phase vapeur à des températures inférieures à 1050°C.

7. Procédé de fabrication de couches en métaux durs selon l'une des revendications 1 à 6, caractérisé en ce qu'une couche de boronitrure à strate unique d'une épaisseur de 1 à 10 µm est déposée.

8. Procédé de fabrication de couches en matières dures selon l'une des revendications 1 à 6, caractérisé par un dépôt respectif, sur la couche intermédiaire, d'une série de couches en boronitrure d'une épaisseur respective de 0,5 à 3 µm, en alternance avec des couches en nitrure ou carbonitrure pur d'une épaisseur respective de 0,1 à 1 µm.

9. Procédé de fabrication de couches en matières dures selon l'une des revendications 1 à 6, caractérisée par un dépôt respectif, sur la couche intermédiaire, d'une série de couches en boronitrure d'une épaisseur respective de 0,5 à 3 µm, en alternance avec des couches en oxynitrure ou oxycarbonitrure pur d'une épaisseur respective de 0,1 à 1 µm.

10. Procédé de fabrication de couches en matières dures selon l'une des revendications 8 ou 9, caractérisé en ce que la combinaison de couches qui suit la couche intermédiaire est déposée de manière à former une épaisseur de couche totale comprise entre 1 et 20 µm, de préférence entre 2 et 12 µm.
